# EUROPÄISCHE PATENTSCHRIFT

(11) **EP 1 094 301 B1**
(45) Veröffentlichungstag und Bekanntmachung des Hinweises auf die Patenterteilung: **28.12.2005**
(21) Anmeldenummer: 00121809.8
(22) Anmeldetag: 06.10.2000
(51) Int. Cl.: G01D 5/34, H03K 17/945

(54) **Optischer Sensor**
Optical sensor
Capteur optique

(30) Priorität: 23.10.1999 DE 19951165
(43) Veröffentlichungstag der Anmeldung: 25.04.2001
(73) Patentinhaber: Leuze electronic GmbH + Co KG, 73277 Owen/Teck (DE)
(72) Erfinder: Hofgärtner, Gerhard, 72622 Nürtingen (DE); Haag, Roland, 73278 Schlierbach (DE); Hermle, Axel, 73277 Owen/Teck (DE)
(74) Vertreter: Ruckh, Rainer Gerhard

(56) Entgegenhaltungen:
- CH-A- 677 408
- DE-A- 3 905 163
- DE-A- 4 305 385
- DE-A- 19 747 248
- DE-C- 19 527 175

## Beschreibung

Die Erfindung betrifft einen optischen Sensor gemäß dem Oberbegriff des Anspruchs 1.

Derartige Sensoren können insbesondere als Lichtschranken oder Reflexionslichtschranken ausgebildet sein. Diese weisen einen Sendelichtstrahlen emittierenden Sender und einen Empfangslichtstrahlen empfangenden Empfänger zur Erfassung von Objekten in einem Überwachungsberich auf. Dabei wird durch die auf den Empfänger auftreffenden Empfangslichtstrahlen am Ausgang des Empfänger ein Empfangssignal generiert, welches in einer Auswerteeinheit mit einem Schwellwert bewertet wird. Dadurch wird ein binären Schaltsignal generiert. Je nachdem ob das Empfangssignal oberhalb oder unterhalb des Schwellwerts liegt, nimmt das Schaltsignal den Schaltzustand "Objekt vorhanden" oder "kein Objekt vorhanden" ein. Dieses Schaltsignal wird über einen Schaltausgang aus dem Sensor ausgegeben und beispielsweise in eine SPS (speicherprogrammierbare Steuerung) eingelesen. Hierzu wird die eine externe Last bildende SPS über Leitungen an den Schaltausgang sowie an einen Anschluss für die positive oder negative Betriebsspannung des Sensors angeschlossen. Das Schaltsignal am Schaltausgang wird dann je nach Ausprägung des Sensors gegen die positive oder negative Betriebsspannung geschaltet.

Nachteilig hierbei ist jedoch, dass die Sensoren nur eine bestimmte Anschlusskonfiguration zulassen. Soll für einen Sensor die Anschlusskonfiguration geändert werden, muss die Beschaltung des Sensors entsprechend geändert werden. Dies erfordert einen zusätzlichen Schaltungsaufwand und führt zu einer unerwünschten Erhöhung der Herstellkosten. Zudem werden für die Auswerteeinheiten von optischen Sensoren bereits integrierte Schaltkreise, insbesondere ASIC eingesetzt, um eine möglichst geringe Baugröße der Sensoren zu erhalten. Eine Zusatzbeschaltung zu einem ASIC bedingt jedoch wieder einen zusätzlichen Platzbedarf im Sensor.

Um derartige Zusatzbeschaltungen zu vermeiden können Sensoren in den verschiedenen Anschlusskonfigurationen in ausreichender Zahl auf Lager gelegt und bei Bedarf ausgelagert werden, um die jeweiligen Applikationen zu bedienen. Damit ist jedoch eine aufwendige Lagerhaltung und ein entsprechender Kostenaufwand verbunden.

Ein gattungsgemäßer optischer Sensor ist aus der DE-A-4305386 bekannt. Dieser bildet einen Näherungsschalter mit mindestens drei Anschlüssen, mit einem Sensor zur Erfassung eines sich annähernden Auslösers, und mit einer Auswertestufe zur Umwandlung des Sensorsignals in ein binäres Signal, welches einen elektronischen Lastschalter schaltet. Der Näherungsschalter weist dabei zwei alternativ genutzte Lastschalter auf, wobei eine Abfrageeinrichtung bei Inbetriebnahme des Näherungsschalters abfragt, zwischen welchem Paar von Anschlüssen die zu schaltende Last liegt, und über eine Programmierschaltung nicht benötigten elektronischen Lastschaltern dauerhaft sperrt und den anderen Lastschalter für eine Betätigung durch das binäre Sensorausgangssignal bereitstellt.

Der Erfindung liegt die Aufgabe zugrunde einen Sensor der eingangs genannten Art so auszubilden, dass bei möglichst geringem Schaltungsaufwand eine möglichst universelle Anschlussmöglichkeit an externe Geräte gewährleistet ist.

Zur Lösung dieser Aufgabe sind die Merkmale des Anspruchs 1 vorgesehen. Vorteilhafte Ausführungsformen und zweckmäßige Weiterbildungen der Erfindung sind in den Unteransprüchen beschrieben.

Die Auswerteeinheit des erfindungsgemäßen optischen Sensors weist einen integrierten Schaltkreis in Form eines ASIC auf. In diesem ASIC sind der Anschluss für die positive Betriebsspannung und der Schaltausgang über einen ersten Schalter gekoppelt. Der Anschluss für die negative Betriebsspannung und der Schaltausgang sind über einen zweiten Schalter gekoppelt. Die Schalter sind über ein Steuersignal steuerbar, so dass wenigstens einer der Schalter in Abhängigkeit des binären Schaltsignals gesteuert ist und höchstens einer der Schalter einen unveränderlichen Schaltzustand aufweist.

Über das Steuersignal werden die Schalter somit derart angesteuert, dass ohne eine Zusatzbeschaltung der Sensor für unterschiedliche Anschlussmöglichkeiten einer externen Last wie zum Beispiel einer SPS konfigurierbar ist.

Die Vorgabe des Steuersignals erfolgt durch eine geeignete Programmierung während des Produktionsprozesses des Sensors.

Je nach Ausbildung des Sensors können auch mehrere derartige Schaltausgänge am Sensor vorgesehen sein. Dabei können über die Schaltausgänge insbesondere Objektmeldungen oder auch Warn- oder Fehlermeldungen in Form von binären Schaltsignalen ausgegeben werden.

Je nach Ansteuerung der Schalter über das Steuersignal werden insbesondere die folgenden Anschlussmöglichkeiten einer externen Last an den Sensor erhalten.

Wird über das Steuersignal der erste Schalter dauernd geöffnet und der zweite Schalter in Abhängigkeit des binären Schaltsignals gesteuert, so kann die externe Last über Leitungen zwischen dem Schaltausgang und dem Anschluss für die positive Betriebsspannung angeschlossen werden.

Wird über das Steuersignal der zweite Schalter dauernd geöffnet und der erste Schalter in Abhängigkeit des binären Schaltsignals gesteuert, so kann die externe Last über Leitungen zwischen dem Schaltausgang und dem Anschluss für die negative Betriebsspannung angeschlossen werden.

Gemäß einer weiteren Variante werden der erste und der zweite Schalter im Gegentakt vom binären Schaltsignal gesteuert. Auf diese Weise wird ein Gegentakt-Ausgang des Sensors erhalten, an welchen eine externe Last sowohl zwischen dem Schaltausgang und dem Anschluss für die positive Betriebsspannung als auch zwischen dem Schaltausgang und dem Anschluss für die negative Betriebsspannung anschließbar ist.

Die Erfindung wird im nachstehenden anhand der Zeichnungen erläutert. Es zeigen:
- Figur 1:: Schematische Darstellung eines Ausführungsbeispiels eines optischen Sensors mit einem Schaltausgang und Anschlüssen für die positive und negative Betriebsspannung.
- Figur 2:: Erstes Ausführungsbeispiel einer Anschaltungskonfiguration des Schaltausgangs und der Anschlüsse für die positive und negative Betriebsspannung des Sensors gemäß Figur 1.
- Figur 3:: Zweites Ausführungsbeispiel einer Anschaltungskonfiguration des Schaltausgangs und der Anschlüsse für die positive und negative Betriebsspannung des Sensors gemäß Figur 1.
- Figur 4:: Drittes Ausführungsbeispiel einer Anschaltungskonfiguration des Schaltausgangs und der Anschlüsse für die positive und negative Betriebsspannung des Sensors gemäß Figur 1.

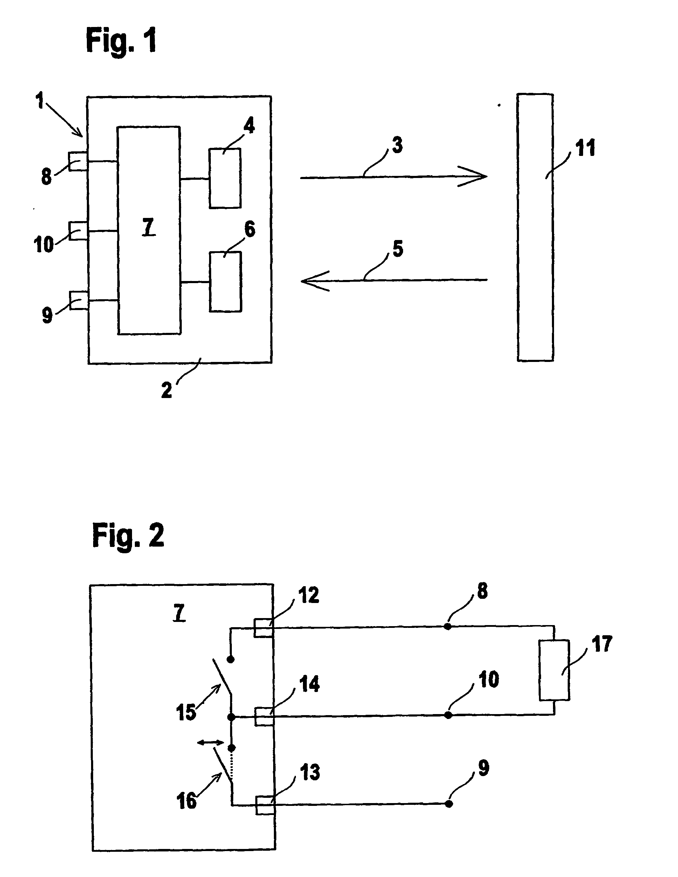

Figur 1 zeigt den Aufbau eines optischen Sensors 1 zur Erfassung von Objekten in einem Überwachungsbereich. Prinzipiell kann der optische Sensor 1 von einer Einweglichtschranke, einem Lichttaster oder dergleichen gebildet sein. Im vorliegenden Ausführungsbeispiel ist der optische Sensor 1 von einer Reflexionslichtschranke gebildet.

Der Sensor 1 ist in einem Gehäuse 2 integriert und weist einen Sendelichtstrahlen 3 emittierenden Sender 4 sowie einen Empfangslichtstrahlen 5 empfangenden Empfänger 6 auf. Der Sender 4 besteht vorzugsweise aus einer Leuchtdiode, der Empfänger 6 aus einer Photodiode. Die Sendelichtstrahlen 3 werden über eine nicht dargestellte Sendeoptik in den Überwachungsbereich geführt. Die aus dem Überwachungsbereich zurück zum Sensor 1 reflektierten Empfangslichtstrahlen 5 werden über eine ebenfalls nicht dargestellte Empfangsoptik zurück zum Empfänger 6 geführt.

Der Sender 4 und der Empfänger 6 sind an eine Auswerteeinheit angeschlossen. Die Auswerteeinheit besteht im wesentlichen aus einem integrierten Schaltkreis, vorzugsweise einem ASIC 7. Auf dieses ASIC 7 sind Anschlüsse 8, 9 für die positive und negative Betriebsspannung sowie ein Schaltausgang 10 geführt.

Der Überwachungsbereich der vom Sensor 1 erfasst wird, ist von einem Reflektor 11 begrenzt. Bei freiem Strahlengang treffen die Sendelichtstrahlen 3 auf den Reflektor 11 und werden von dort als Empfangslichtstrahlen 5 auf den Empfänger 6 zurückreflektiert. Befindet sich ein Objekt im Strahlengang, gelangen die Sendelichtstrahlen 3 nicht mehr zum Reflektor 11 und werden vom Objekt als Empfangslichtstrahlen 5 zum Empfänger 6 zurückreflektiert.

Je nachdem, ob sich ein Objekt im Strahlengang befindet oder nicht, ergibt sich durch die auftreffenden Empfangslichtstrahlen 5 am Ausgang des Empfängers 6 ein Empfangssignal mit einem entsprechenden Pegel. In der Auswerteeinheit wird das Empfangssignal mit einem Schwellwert bewertet, wodurch ein binäres Schaltsignal generiert wird.

Ist ein Objekt im Strahlengang vorhanden, so liegt das Empfangssignal unterhalb des Schwellwerts und das binäre Schaltsignal nimmt den Schaltzustand "Objekt vorhanden" ein. Liegt ein freier Strahlengang vor, so liegt das Empfangssignal unterhalb des Schwellwerts und das binäre Schaltsignal nimmt den Schaltzustand "kein Objekt vorhanden" ein.

Dieses binäre Schaltsignal wird über den Schaltausgang 10 ausgegeben.

In Erweiterung des in Figur 1 dargestellten Ausführungsbeispiels kann das binäre Schaltsignal auch über mehrere Schaltausgänge ausgegeben werden. Vorzugsweise können zwei antivalente Schaltausgänge vorgesehen sein.

Als zusätzliche Erweiterung des in Figur 1 dargestellten Ausführungsbeispiels kann das Empfangssignal auch mit weiteren Schwellwerten bewertet werden, um die Funktionsfähigkeit des Sensors 1 zu überprüfen. In diesem Fall werden aus dem Empfangssignal weitere binäre Schaltsignale gebildet, welche als Fehlermeldungen oder Warnmeldungen über separate Schaltausgänge ausgegeben werden.

Sämtliche dieser Schaltausgänge sind vorzugsweise in gleicher Weise an die Auswerteeinheit angeschlossen.

In den Figuren 2 - 4 ist schematisch das ASIC 7 der Auswerteeinheit mit unterschiedlichen Beschaltungen des Schaltausgangs 10 und der Anschlüsse 8, 9 für die positive und negative Betriebsspannung dargestellt. Der Schaltausgang 10 und die Anschlüsse 8, 9 für die positive und negative Betriebsspannung sind über jeweils eine Leitung auf einen Anschlusspin 12, 13, 14 des ASIC 7 geführt.

Die Anschlüsse 8, 9 für die positive uns negative Betriebsspannung sowie der Schaltausgang 10 sind auf ein ebenfalls nicht dargestelltes Anschlussmodul wie beispielsweise einen Stecker im Gehäuse 2 des Sensors 1 geführt.

Der Sensor 1 ist für positive Betriebsspannungen im Bereich von 10V bis 30V ausgelegt, wobei die Betriebsspannung vorzugsweise 24V beträgt. Wie aus den Figuren 2 - 4 ersichtlich ist, ist im ASIC 7 ein einen ersten Schalter 15 bildenden Transistor vorgesehen, über welchen der Anschlusspin 12 für die positive Betriebsspannung mit dem Anschlusspin 14 für den Schaltausgang 10 gekoppelt ist. Zudem ist ein weiterer, einen zweiten Schalter 16 bildenden Transistor vorgesehen, über welchen der Anschlusspin 13 für die negative Betriebsspannung mit dem Anschlusspin 14 für den Schaltausgang 10 gekoppelt ist. Die Transistoren sind vorzugsweise als Leistungstransistoren ausgebildet und bestehen aus MOSFET-Transistoren oder dergleichen.

Die Schalter 15, 16 werden über ein Steuersignal des ASIC 7 gesteuert. Die Vorgabe des Steuersignals kann insbesondere bei der Programmierung des ASIC 7 erfolgen. Diese Programmierung erfolgt vorzugsweise während des Produktionsprozesses und bleibt dann während des Einsatzes des Sensors 1 unverändert erhalten. Prinzipiell kann eine derartige Programmierung auch während des Einsatzes des Sensors 1 bei einer bestimmten Applikation erfolgen.

Alternativ kann das Steuersignal über einen Steuereingang des ASIC 7 eingegeben werden, der von einem nicht dargestellten weiteren Anschlusspin des ASIC 7 gebildet ist.

Erfindungsgemäß werden je nach Vorgabe des Steuersignals bestimmte Anschlusskonfigurationen für den optischen Sensor 1 erhalten. Dabei sind die Schalter 15, 16 in Abhängigkeit des Steuersignals so steuerbar, dass wenigstens einer der Schalter 15, 16 in Abhängigkeit des binären Schaltsignals gesteuert ist und höchstens einen der Schalter 15, 16 einen unveränderlichen Schaltzustand aufweist. Die unterschiedlichen Anschlusskonfigurationen des optischen Sensors 1 sind in den Figuren 2 - 4 dargestellt.

Bei der in Figur 2 dargestellten Anschlusskonfiguration ist über das Steuersignal der erste Schalter 15 dauernd geöffnet. Der zweite Schalter 16 wird dagegen über das binäre Schaltsignal angesteuert. Somit wechselt der zweite Schalter 16 entsprechend dem momentanen Schaltzustand des binären Schaltsignals einen Schaltzustand. Bei dieser Anschlusskonfiguration weist der optische Sensor 1 einen sogenannten Low-Side-Ausgang auf. In diesem Fall wird eine externe Last 17 wie in Figur 2 dargestellt zwischen den Anschluss 8 für die positive Betriebsspannung und den Schaltausgang 10 angeschlossen. Mittels des so ausgebildeten Low-Side-Ausgangs wird die externe Last 17 gegen die negative Betriebsspannung, das heißt gegen das Massepotential geschaltet.

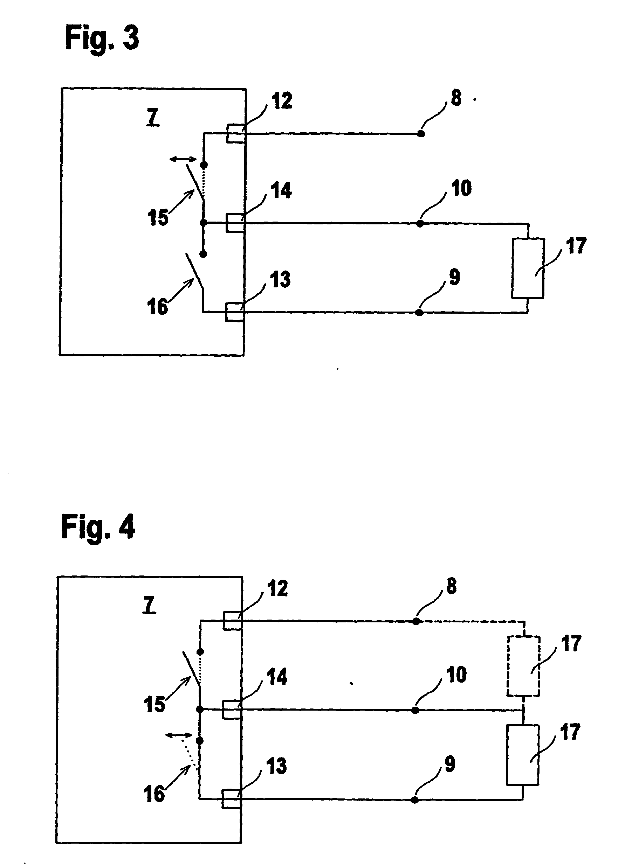

Bei der in Figur 3 dargestellten Anschlusskonfiguration ist über das Steuersignal der zweite Schalter 16 dauernd geöffnet. Der erste Schalter 15 wird dagegen über das binäre Schaltsignal angesteuert. Somit wechselt der erste Schalter 15 entsprechend dem momentanen Schaltzustand des binären Schaltsignals seinen Schaltzustand. Bei dieser Anschlusskonfiguration weist der optische Sensor 1 einen sogenannten High-Side-Ausgang auf. In diesem Fall wird eine externe Last 17 wie in Figur 3 dargestellt zwischen den Anschluss 9 für die negative Betriebsspannung und den Schaltausgang 10 angeschlossen. Mittels des so ausgebildeten High-Side-Ausgangs wird die externe Last 17 gegen die positive Betriebsspannung geschaltet.

Bei der in Figur 4 dargestellten Anschlusskonfiguration wird über das Steuersignal das binäre Schaltsignal auf beide Schalter 15, 16 gelegt. Dabei werden die Schalter 15, 16 im Gegentakt vom binären Schaltsignal angesteuert. Demzufolge ist der zweite Schalter 16 immer dann geöffnet wenn der erste Schalter 15 geschlossen ist und umgkehrt. Diese Anschlusskonfiguration bildet einen sogenannten Gegentakt-Ausgang. Bei dieser Anschlusskonfiguration kann die externe Last 17 sowohl zwischen die positive Betriebsspannung und den Schaltausgang 10 als auch zwischen die negative Betriebsspannung und den Schaltausgang 10 angeschlossen werden. Die beiden Anschlussmöglichkeiten sind mit ausgezogenen und gestrichelten Linien in Figur 4 entsprechend angedeutet.

### Bezugszeichenliste

- (1): Optischer Sensor
- (2): Gehäuse
- (3): Sendelichtstrahlen
- (4): Sender
- (5): Empfangslichtstrahlen
- (6): Empfänger
- (7): ASIC
- (8): Anschluss
- (9): Anschluss
- (10): Schaltausgang
- (11): Reflektor
- (12): Anschlusspin
- (13): Anschlusspin
- (14): Anschlusspin
- (15): Schalter
- (16): Schalter
- (17): externe Last

## Patentansprüche

1. Optischer Sensor zur Erfassung von Objekten in einem Überwachungsbereich mit einem Sendelichtstrahlen emittierenden Sender, einem Empfangslichtstrahlen empfangenden Empfänger sowie einer Auswerteeinheit, in welcher in Abhängigkeit der Empfangssignale am Ausgang des Empfängers wenigstens ein binäres Schaltsignal generiert wird, welches über wenigstens einen Schaltausgang ausgebbar ist, wobei die Auswerteeinheit jeweils einen Anschluss für die positive und negative Betriebsspannung aufweist, wobei eine externe Last über Leitungen zwischen dem Schaltausgang einerseits und dem Anschluss für die positive oder negative Betriebsspannung andererseits anschließbar ist und wobei der Schaltausgang mit dem Anschluss für die positive Betriebsspannung über einen ersten Schalter gekoppelt ist und der Schaltausgang mit dem Anschluss für die negative Betriebsspannung über einen zweiten Schalter gekoppelt ist, **dadurch gekennzeichnet, dass** die Auswerteeinheit einen integrierten Schaltkreis in Form eines ASIC aufweist und wobei die Schalter (15, 16) im ASIC über ein vorgebbares Steuersignal steuerbar sind, so dass einer der Schalter (15, 16) in Abhängigkeit des binären Schaltsignals gesteuert und der andere Schalter (15, 16) im Gegentakt zum ersten Schalter (15, 16) von dem binären Schaltsignal gesteuert ist oder dauernd geöffnet ist, wobei die Vorgabe des Steuersignals über eine Programmierung des ASIC während des Produktionsprozesses erfolgt.

2. Optischer Sensor nach Anspruch 1, **dadurch gekennzeichnet, dass** die Schalter (15, 16) jeweils von einem Transistor gebildet sind.

3. Optischer Sensor nach einem der Ansprüche 1 oder 2, **dadurch gekennzeichnet, dass** die Betriebsspannung im Bereich von 10V - 30V liegt.

4. Optischer Sensor nach einem der Ansprüche 1 - 3, **dadurch gekennzeichnet, dass** das Steuersignal über einen Steuereingang des ASIC (7) eingebbar ist.

5. Optischer Sensor nach einem der Ansprüche 1 - 4, **dadurch gekennzeichnet, dass** mehrere Schaltsignale über separate Schaltausgänge ausgebbar sind.

6. Optischer Sensor nach einem der Ansprüche 1 - 5, **dadurch gekennzeichnet, dass** die Schaltzustände des oder wenigstens eines Schaltsignals signalisieren, ob ein Objekt im Überwachungsbereich vorhanden ist oder nicht.

7. Optischer Sensor nach einem der Ansprüche 1 - 6, **dadurch gekennzeichnet, dass** die Schaltzustände des oder wenigstens eines Schaltsignals signalisieren, ob eine fehlerfreie Funktion vorliegt oder nicht.

## Claims

1. Optical sensor for detecting objects in a monitoring region, with a transmitter emitting transmitted light beams, a receiver receiving received light beams and an evaluating unit in which at least one binary switching signal is generated at the output of the receiver in dependence on the received signals, which switching signal can be issued by way of at least one switching output, wherein the evaluating unit has at least one connection for positive and negative operating voltage, wherein an external load can be connected by way of lines between the switching output on the one hand and the connection for the positive or negative operating voltage on the other hand and wherein the switching output is coupled with the connection for the positive operating voltage by way of a first switch and the switching output is coupled with the connection for the negative operating voltage by way of a second switch, **characterised in that** the evaluating unit is an integrated circuit in the form of an ASIC and wherein the switches (15, 16).in the ASIC are controllable by way of a predeterminable control signal so that one of the switches (15, 16) is controlled in dependence on the binary switching signal and the other switch (15, 16) is controlled by the binary switching signal in opposite phase to the first switch (15, 16) or is permanently opened, wherein the presetting of the control signal is carried out by way of programming of the ASIC during the production process.

2. Optical sensor according to claim 1, **characterised in that** the switches (15, 16) are each formed by a respective transistor.

3. Optical sensor according to one of claims 1 and 2, **characterised in that** the operating voltage lies in the range of 10 V to 30 V.

4. Optical sensor according to one of claims 1 to 3, **characterised in that** the control signal can be input by way of a control input of the ASIC (7).

5. Optical sensor according to one of claims 1 to 4, **characterised in that** several switching signals can be output by way of separate switching outputs.

6. Optical sensor according to one of claims 1 to 5, **characterised in that** the switching states of the or at least one switching signal signal whether or not an object is present in the monitoring region.

7. Optical sensor according to one of claims 1 to 6, **characterised in that** the switching states of the or at least one switching signal signal whether or not a fault-free function is present.

## Revendications

1. Capteur optique pour la saisie d'objets dans une zone de surveillance, comprenant un émetteur émettant des rayons lumineux d'émission, un récepteur recevant des rayons lumineux de réception ainsi qu'une unité d'évaluation dans laquelle, en fonction des signaux de réception à la sortie du récepteur, est généré au moins un signal logique ou de commutation binaire qui peut être délivré par au moins une sortie logique, dans lequel l'unité d'évaluation présente chaque fois une connexion pour la tension de fonctionnement positive et négative, dans lequel une charge externe peut être connectée par des lignes entre la sortie logique ou de commutation d'une part et la connexion pour la tension de fonctionnement positive ou négative d'autre part, et dans lequel la sortie logique ou de commutation est couplée avec la connexion pour la tension de fonctionnement positive par un premier commutateur et la sortie logique ou de commutation est couplée avec la connexion pour la tension de fonctionnement négative par un deuxième commutateur, **caractérisé par le fait que** l'unité d'évaluation présente un circuit intégré sous la forme d'un ASIC et que les commutateurs (15, 16) contenus dans l'ASIC peuvent être commandés par un signal de commande pouvant être défini de telle manière que l'un des commutateurs (15, 16) soit commandé en fonction du signal logique binaire et que l'autre commutateur (15, 16) soit commandé par le signal logique binaire de façon symétrique par rapport au premier commutateur (15, 16) ou ouvert en permanence, le signal de commande étant défini par une programmation de l'ASIC pendant le processus de production.

2. Capteur optique selon la revendication 1, **caractérisé par le fait que** les commutateurs (15, 16) sont formés chacun par un transistor.

3. Capteur optique selon l'une des revendications 1 ou 2, **caractérisé par le fait que** la tension de fonctionnement se situe dans la plage de 10 V à 30 V.

4. Capteur optique selon l'une des revendications 1 à 3, **caractérisé par le fait que** le signal de commande peut être entré par une entrée de commande de l'ASIC (7).

5. Capteur optique selon l'une des revendications 1 à 4, **caractérisé par le fait que** plusieurs signaux logiques peuvent être délivrés par des sorties logiques séparées.

6. Capteur optique selon l'une des revendications 1 à 5, **caractérisé par le fait que** les états logiques du ou d'au moins un signal logique signalent si un objet est présent ou non dans la zone de surveillance.

7. Capteur optique selon l'une des revendications 1 à 6, **caractérisé par le fait que** les états logiques du ou d'au moins un signal logique signalent si le fonctionnement est correct ou non.
